# EUROPÄISCHE PATENTSCHRIFT

(11) **EP 3 738 214 B1**
(45) Veröffentlichungstag und Bekanntmachung des Hinweises auf die Patenterteilung: **09.11.2022**
(21) Anmeldenummer: 19701486.3
(22) Anmeldetag: 21.01.2019
(51) Int. Cl.: H04B 1/28, G08G 1/0967, G08G 1/16, H04B 1/40, H04W 4/46, H04W 4/44, H04B 1/04, H04B 1/18, H04B 1/3822, H04W 4/40

(54) **SYSTEME ZUM TRANSPORT VON EXTERN EMPFANGENEN SIGNALEN INNERHALB EINES KRAFTFAHRZEUGS**
SYSTEMS FOR TRANSPORTING EXTERNALLY RECEIVED SIGNALS WITHIN A MOTOR VEHICLE
SYSTÈMES DE TRANSPORT DE SIGNAUX REÇUS DE L'EXTÉRIEUR DANS UN VÉHICULE AUTOMOBILE

(30) Priorität: 20.02.2018 DE 102018202544
(43) Veröffentlichungstag der Anmeldung: 18.11.2020
(73) Patentinhaber: Audi AG, 85045 Ingolstadt (DE)
(72) Erfinder: SPEHL, Jürgen, 85139 Wettstetten (DE)
(74) Vertreter: Raible Deissler Lehmann Patentanwälte PartG mbB
(86) Internationale Anmeldenummer: PCT/EP2019/051309
(87) Internationale Veröffentlichungsnummer: WO 2019/162005

(56) Entgegenhaltungen:
- DE-A1-102015 201 476
- DE-A1-102016 007 193
- DE-A1-102016 203 160
- DE-T2- 60 218 101
- DE-T2- 69 219 809
- US-A1- 2009 021 436

## Beschreibung

Die Erfindung betrifft ein System und ein Verfahren zum Übermitteln von Signalen.

Zwischen zwei Vorrichtungen, bspw. zwischen zwei Fahrzeugen, können Signale per Funk über elektromagnetische Wellen ausgetauscht werden. Dabei weisen diese Signale üblicherweise eine definierte Frequenz auf. Sobald ein derartiges Signal von einer der Vorrichtungen, üblicherweise ihrer Antenne, empfangen worden ist, wird es innerhalb der Vorrichtung weiterverarbeitet.

Die Druckschrift DE 10 2016 211 890 A1 beschreibt eine Antenne für ein Fahrzeug, die dazu ausgebildet ist, Radiowellensignale im Millimeterband für eine Kommunikation der fünften Generation (5G) zu übertragen und zu empfangen.

Außerdem wird auf die Druckschriften US 2017/110790 A1 und US 2017/149130 A1 verwiesen, in denen ähnliche Antennen beschrieben sind.

Die Druckschrift US 2009/021436 A1 beschreibt ein Kommunikationssystem mit einem Antennenarray mit einem Speisenetz, das an eine Kommunikationselektronik gekoppelt ist. Dabei umfasst ein Kommunikationssubsystem mehrere Antennen, die jeweils zum Empfangen eines Informationssignals angepasst sind, und mehrere Orthomode-Wandler, die mit den Antennen gekoppelt und dazu ausgebildet sind, unterschiedliche Komponentensignale unterschiedlich zu polarisieren.

Ein Hochfrequenzschaltungsmodul ist aus der Druckschrift DE 602 18 101 T2 bekannt. Dabei sind auf beiden Seiten eines mehrschichtigen dielektrischen Substrats Hochfrequenzschaltungsteile für ein Millimeterwellensignal und Übertragungsleitungen zur Verbindung der Hochfrequenzschaltungsteile angebracht.

Eine integrierte Antennen/Empfänger-Einheit ist in der Druckschrift DE 692 19 809 T2 beschrieben. Die Einheit umfasst eine RF-Antenne mit einer Anzahl von Antennenelementen, einen RF-Empfänger mit derselben Anzahl an RF-Eingängen und zumindest dieselbe Anzahl an RF-Verstärkern.

Die Druckschrift DE 10 2016 007 193 A1 beschreibt ein Funkmodem für ein Kraftfahrzeug mit einer Antennenanordnung, einem AD-DA-Wandler und einem Prozessor zum Austauschen von Kommunikationsdaten zwischen dem Kraftfahrzeug und zumindest einem Objekt in einer Umgebung des Kraftfahrzeugs.

Ein Kommunikationsadapter zum Verbinden einer Kommunikationsantenne mit einem Car2X-Fahrzeugkommunikationsgerät ist aus der Druckschrift DE 10 2015 201 476 A1 bekannt. Der Kommunikationsadapter umfasst eine digitale Busschnittstelle zum Empfangen eines digitalen Signals von dem Car2X-Fahrzeugkommunikationsgerät, einen Car2X-Transceiver zum Generieren eines analogen Sendesignals auf der Grundlage des digitalen Signals und eine Antennenschnittstelle zum Übertragen des analogen Sendesignals.

Ein Radarsystem, das eine Antennenanordnung zum Senden und Empfangen von elektromagnetischer Strahlung aufweist, ist aus der Druckschrift DE 10 2016 203 160 A1 bekannt. Dabei werden zueinander orthogonale Sendesignale durch Frequenzmultiplex realisiert. In das Radarsystem ist ein Analog-/Digitalwandler integriert.

Vor diesem Hintergrund war es eine Aufgabe, Signale, die per Funk von einer Antenne empfangen werden, für eine weitere Bearbeitung anzupassen.

Diese Aufgabe wird durch ein System und ein Verfahren mit den Merkmalen der unabhängigen Patentansprüche gelöst. Ausführungsformen des Systems und des Verfahrens gehen aus den abhängigen Patentansprüchen hervor.

Das erfindungsgemäße System ist zum Austauschen von Signalen zwischen einem Gerät eines Fahrzeugs und einer externen Vorrichtung außerhalb des Fahrzeugs über mindestens eine Antenne des Fahrzeugs ausgebildet, wobei hochfrequente Signale, d. h. Signale, die eine Frequenz mit einem ersten hohen Wert aufweisen, und ggf. analog sind, zwischen der mindestens einen externen Vorrichtung und der mindestens einen Antenne des Fahrzeugs über elektromagnetische Wellen auszutauschen sind bzw. ausgetauscht werden. Die mindestens eine Antenne ist über mindestens einen ersten Pfad mit einem ersten Ende einer bspw. aus Metall bestehenden, elektrisch leitfähigen Leitung des Fahrzeugs verbunden. Das Gerät ist über mindestens einen zweiten Pfad mit einem zweiten Ende der Leitung des Fahrzeugs verbunden. Das System weist mindestens ein als Frequenzreduktionsmodul ausgebildetes Signalwandlungsmodul auf, das entlang mindestens eines der Pfade, d. h. insbesondere entlang des ersten Pfads und/oder entlang des zweiten Pfads, angeordnet ist. Das mindestens eine Frequenzreduktionsmodul ist dazu ausgebildet, den hohen Wert der Frequenz der jeweiligen hochfrequenten Signale vor einem Transport entlang der Leitung auf einen bspw. vorgegebenen zweiten reduzierten bzw. niedrigen Wert einzustellen und demnach niederfrequente Signale zu erzeugen.

Das erfindungsgemäße System ist ebenfalls zum Austauschen von Signalen zwischen einem Gerät eines Fahrzeugs und einer externen Vorrichtung außerhalb des Fahrzeugs über mindestens eine Antenne des Fahrzeugs ausgebildet, wobei hochfrequente Signale, d. h. Signale, die üblicherweise eine Frequenz mit einem hohen Wert aufweisen, und analog sind bzw. eine analoge Struktur aufweisen, zwischen der mindestens einen externen Vorrichtung und der mindestens einen Antenne des Fahrzeugs über elektromagnetische Wellen auszutauschen sind bzw. ausgetauscht werden. Die mindestens eine Antenne ist über mindestens einen ersten Pfad mit einem ersten Ende einer bspw. aus Metall bestehenden, elektrisch leitfähigen Leitung des Fahrzeugs verbunden. Das Gerät ist auch über mindestens einen zweiten Pfad mit einem zweiten Ende der Leitung des Fahrzeugs verbunden. Das System weist mindestens ein als Analog-Digital-Wandler ausgebildetes Signalwandlungsmodul auf, der entlang mindestens eines der beiden Pfade, d. h. insbesondere entlang des ersten Pfads und/oder entlang des zweiten Pfads, angeordnet ist. Der mindestens eine Analog-Digital-Wandler ist als Strukturwandlungsmodul dazu ausgebildet, die Signale vor einem Transport entlang der Leitung zu digitalisieren, d. h. deren Struktur bzw. Form von analog zu digital zu wandeln.

Bei dem System ist es möglich, dass die mindestens eine Antenne und mindestens ein Signalwandlungsmodul, d. h. das Frequenzreduktionsmodul bzw. der Digital-Analog-Wandler, entlang des mindestens einen ersten Pfads bzw. an dem ersten Ende der Leitung des Fahrzeugs in und/oder auf einem gemeinsamen Chip und/oder Baustein, bspw. Halbleiterelement, angeordnet sind.

Das System weist mindestens ein als Frequenzerhöhungsmodul ausgebildetes Signalwandlungsmodul, insbesondere Frequenzwandlungsmodul, und mindestens ein als Digital-Analog-Wandler ausgebildetes Signalwandlungsmodul, insbesondere Strukturwandlungsmodul, auf, die entlang mindestens eines der Pfade angeordnet sind. Das mindestens eine Frequenzerhöhungsmodul des Systems ist dazu ausgebildet, den niedrigen Wert der Frequenz der niederfrequenten Signale nach dem Transport entlang der Leitung wieder auf den ursprünglich hohen Wert der Frequenz einzustellen. Ergänzend ist der mindestens eine Digital-Analog-Wandler des Systems dazu ausgebildet, die Signale nach dem Transport entlang der Leitung zu analogisieren, d. h. deren Struktur bzw. Form von digital zu analog zu wandeln.

Das System weist das mindestens eine als Frequenzerhöhungsmodul ausgebildete Signalwandlungsmodul und das mindestens eine als Analog-Digital-Wandler ausgebildete Signalwandlungsmodul auf und weist ggf. auch das mindestens eine Frequenzerhöhungsmodul und den mindestens einen Digital-Analog-Wandler auf. Mindestens eines der genannten Signalwandlungsmodule ist entlang mindestens eines der beiden beschriebenen Pfade angeordnet.

Das erfindungsgemäße Verfahren ist zum Austauschen von Signalen zwischen mindestens einem Gerät eines Fahrzeugs und mindestens einer externen Vorrichtung mit einer Ausführungsform des vorgestellten Systems ausgebildet und/oder vorgesehen.

Bei dem Verfahren wird und/oder ist vorgesehen, dass zwischen mindestens einer Antenne des Fahrzeugs und der externen Vorrichtung, bspw. einer Antenne dieser Vorrichtung, über elektromagnetische Wellen hochfrequente Signale ausgetauscht werden, die eine Frequenz mit einem hohen Wert aufweisen und bspw. auch analog sind. Die mindestens eine Antenne ist über mindestens einen ersten Pfad mit einem ersten Ende einer Leitung des Fahrzeugs und das Gerät über mindestens einen zweiten Pfad mit einem zweiten Ende der Leitung des Fahrzeugs verbunden. Bei dem Verfahren wird mit mindestens einem als Frequenzreduktionsmodul ausgebildeten Signalwandlungsmodul, das entlang mindestens eines der Pfade angeordnet ist, der hohe Wert der Frequenz der Signale vor einem Transport entlang der Leitung auf den niedrigen Wert eingestellt. Ergänzend werden bei dem Verfahren mit mindestens einem als Analog-Digital-Wandler ausgebildeten Signalwandlungsmodul, der entlang mindestens eines der beiden Pfade angeordnet ist, die analogen und hochfrequenten Signale vor einem Transport entlang der Leitung digitalisiert.

Der hohe Wert der Frequenz der hochfrequenten Signale ist mindestens so groß wie 5 GHz, vorzugsweise mindestens so groß wie 5,9 GHz, besonders bevorzugt mindestens so groß wie 6 GHz, weiter bevorzugt mindestens so groß wie 26 GHz, noch weiter bevorzugt mindestens so groß wie 28 GHz oder mindestens so groß wie 70 GHz.

Bei dem Verfahren werden Signale, die entlang der Leitung transportiert werden, niederfrequent bzw. auf eine Frequenz mit einem niedrigen Wert eingestellt und/oder digitalisiert, wohingegen die Signale zum Transport über elektromagnetische Wellen hochfrequent eingestellt sind bzw. werden sowie analog sind bzw. analog eingestellt werden.

Die Frequenz mit dem niedrigen Wert entspricht mindestens einem einstelligen ganzzahligen Teil des hohen Werts der Frequenz, bspw. maximal 2 GHz oder maximal als 1 GHz.

Bei der Kommunikation zwischen dem mindestens einen Gerät des Fahrzeugs und der mindestens einen Vorrichtung außerhalb des Fahrzeugs durch Austauschen und somit Senden und/oder Empfangen von Signalen über elektromagnetische Wellen wird für diese Signale für einen Standard 5 G gemäß einer fünften Generation für mobile Netzwerke die erste hohe Frequenz für die hochfrequenten Signale verwendet, die einen Wert aufweist, der >= 5,9 GHz, >= 6 GHz, >= 26 GHz, >= 28 GHz oder >= 70 GHz ist.

Die hochfrequenten Signale können über unterschiedliche Mobilfunkstandards, bspw. WLAN, pWLAN, LTE, Bluetooth, BTLE, GSM, UMTS zwischen der mindestens einen Antenne und der externen Vorrichtung übertragen werden, wobei für die Signale eine hohe Bandbreite erreicht wird.

Im Rahmen des vorgestellten Verfahrens werden die Signale, die die erste hohe Frequenz aufweisen, zwischen der mindestens einen Antenne des Fahrzeugs und der mindestens einen externen Vorrichtung, die eine Antenne aufweist oder als solche ausgebildet ist, außerhalb des Fahrzeugs ausgetauscht. Diese externe Vorrichtung ist bspw. ein weiteres Fahrzeug, eine bspw. ortsfeste Infrastruktureinrichtung oder ein bspw. mobiles Kommunikationsgerät, bspw. ein sogenanntes Handy, Smartphone, ein Laptop oder ein anderer Computer.

Diese von der Antenne empfangenen hochfrequenten und in der Regel analogen Signale werden von dem mindestens einen Signalwandlungsmodul, das der mindestens einen Antenne nachgeschaltet und als Frequenzreduktionsmodul und/oder Analog-Digital-Wandler ausgebildet ist, durch Verringerung der Frequenz von der ersten hohen Frequenz auf die zweite niedrige Frequenz reduziert und/oder durch Digitalisierung digitalisiert.

Hierdurch wird erreicht, dass durch derart modifizierte Signale bei einer weiteren Übertragung innerhalb des Fahrzeugs über die bspw. als Kabel ausgebildete Leitung zu dem mindestens einen Gerät Leitungsverluste und somit Kabelverluste reduziert werden. Falls eine derartige Leitung bspw. als ca. 1,5 Meter langes Koaxialkabel ausgebildet ist, können somit Leitungsverluste vermieden werden, die bei oben genannten Werten für die erste hohe Frequenz der Signale von bspw. 6 GHz ansonsten ca. 57 % betragen können. Somit ist es möglich, eine Leitungsdämpfung bzw. Kabeldämpfung als Leitungsverlust zu reduzieren. Durch Umsetzung des Verfahrens ist es nunmehr auch möglich, Leitungen mit einer Länge von mehreren Metern, bspw. von 6 Metern, zwischen der mindestens einen Antenne und dem mindestens einen Gerät zu verwenden.

Bei dem Verfahren werden zwischen dem mindestens einen bspw. als Steuergerät ausgebildeten Gerät des Fahrzeugs und der mindestens einen externen Vorrichtung, bspw. einem weiteren Fahrzeug, auch Signale ausgetauscht, die Daten aufweisen bzw. beinhalten, die für ein autonomes Fahren des Fahrzeugs verwendet werden. Dabei werden diese Daten zwischen der Antenne des Fahrzeugs und der Vorrichtung direkt ausgetauscht. Somit können bspw. zwei Fahrzeuge über ihre Antennen hochfrequente Signale bspw. direkt austauschen, deren Frequenz zum Transport über eine Leitung zu einem Gerät eines jeweiligen Fahrzeugs reduziert wird, und/oder deren Struktur bzw. Form digitalisiert wird.

Bei dem Verfahren wird durch das mindestens eine als Frequenzreduktionsmodul ausgebildete Signalwandlungsmodul die erste hohe Frequenz als Nutzfrequenz der hochfrequenten Signale im Rahmen einer sogenannten down-conversion auf eine geringere bzw. tiefer liegende Zwischenfrequenz, bspw. auf eine Frequenz mit dem zweiten niedrigen Wert gemischt. Dabei weisen die dabei erzeugten niederfrequenten Signale den zweiten niedrigen Wert für die Frequenz von maximal 2 GHz auf. Hierbei ist es auch möglich, je nach Bandbreite der Frequenzen, die Frequenz von hochfrequenten Signalen ausgehend von dem ersten hohen Wert mehrstufig kaskadiert auf den zu erzielenden zweiten niedrigen Wert zu mischen und somit zu reduzieren, wobei mehrere hintereinander geschaltete Frequenzreduktionsmodule verwendbar sind. Eine hierbei vorgesehene Frequenzverringerung bzw. Frequenzreduktion als mögliche Frequenzwandlung wird durch das mindestens eine Frequenzreduktionsmodul direkt nach der Antenne oder in einem Transceiver, d. h. einem Sender und einem Empfänger, als dem mindestens einen Signalwandlungsmodul durchgeführt, sofern ein Chip bzw. ein elektronischer Baustein, der diesen Transceiver umfasst, mindestens eine eingehende und/oder ausgehende Schnittstelle für Signale mit der jeweils vorgesehenen Frequenz aufweist.

Ergänzend werden hochfrequente Signale mit dem ersten hohen Wert für die Frequenz, die als analoge Signale vorliegen, durch einen Analog-Digital-Wandler als Signalwandlungsmodul digitalisiert.

Es ergeben sich weitere automative Anwendungs- bzw. Applikationsoptionen für die mindestens eine Antenne und das mindestens eine Gerät des Fahrzeugs. So ist es bspw. möglich, durch Multiplexing die zwischen der mindestens einen Antenne und/oder dem mindestens einen Gerät auszutauschenden Signale über lediglich eine Leitung auszutauschen, wobei es möglich ist, dass ein Netzwerk aus mehreren derartigen Leitungen, das die mindestens eine Antenne und/oder das mindestens eine Gerät verbindet, eine sternförmige oder ringförmige Topologie aufweist. Somit ist es möglich, einen Aufwand zum Verlegen von Leitungen bzw. einen Aufwand für eine Verkabelung und daraus resultierende Kosten für eine Infrastruktur zum Verbinden der mindestens einen Antenne und/oder des mindestens einen Geräts in dem Fahrzeug zu senken.

Außerdem ist es möglich, die mindestens eine Antenne und das mindestens eine Signalwandlungsmodul, d. h. das mindestens eine Frequenzreduktionsmodul, das mindestens eine Frequenzerhöhungsmodul, den mindestens einen Analog-Digital-Wandler, den mindestens einen Digital-Analog-Wandler und/oder den mindestens einen Transceiver, im Fall einer aktiven Antenne, direkt im Silikon eines Bausteins als eingebettete Antenne in einem Halbleitersubstrat bzw. Chip zu integrieren. Es ist jedoch auch ein klassischer integrierter Aufbau möglich, der die mindestens eine Antenne, ein Phasenfeld (phase array), ein Ansteuernetzwerk bzw. einen Phasenschieber und ein Transformationsnetzwerk bzw. einen Vorverstärker als das mindestens eine mögliche Signalwandlungsmodul aufweist.

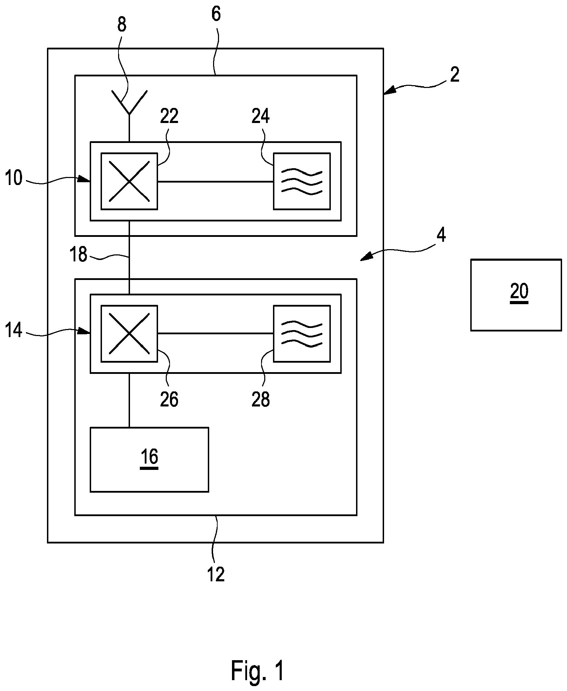

Die Erfindung ist anhand von Ausführungsformen in den Zeichnungen schematisch dargestellt und wird unter Bezugnahme auf die Zeichnungen schematisch und ausführlich beschrieben. Dabei gehören die in den Figuren 1, 2a und 3 dargestellten Beispiele nicht zur Erfindung und werden nicht durch die Ansprüche abgedeckt.

Figur 1 und Figur 2a zeigen in schematischer Darstellung Beispiele eines Systems bei Durchführung eines beispielhaften Verfahrens. Figur 2b zeigt in schematischer Darstellung eine Ausführungsform des erfindungsgemäßen Systems bei Durchführung des erfindungsgemäßen Verfahrens.

Figur 3 zeigt in schematischer Darstellung ein weiteres Beispiel eines Systems bei Durchführung eines weiteren Verfahrens.

Die Figuren werden zusammenhängend und übergreifend beschrieben. Gleichen Bezugsziffern sind dieselben Komponenten zugeordnet. Figur 1 zeigt in schematischer Darstellung ein hier als Kraftfahrzeug ausgebildetes Fahrzeug 2, das ein erstes Beispiel des Systems 4 aufweist. Dabei weist das Fahrzeug 2 eine Kommunikationseinheit 6 auf, die eine Antenne 8 und ein der Antenne 8 nachgeschaltetes Frequenzreduktionsmodul 10 als erstes Frequenzwandlungsmodul und als erstes Signalwandlungsmodul aufweist, wobei die Antenne 8 und das Frequenzreduktionsmodul 10 hier in einen Chip als Baustein integriert sind. Außerdem umfasst das Fahrzeug 2 ein hier als Steuergerät ausgebildetes Gerät 12 mit einem Frequenzerhöhungsmodul 14 als zweitem Frequenzwandlungs- und Signalwandlungsmodul und einem Transceiver 16. Dabei ist vorgesehen, dass die Kommunikationseinheit 6 und das Gerät 12 über eine physische, bspw. aus Kupfer oder einem anderen elektrisch leitfähigen Material gefertigte Leitung 18 des Fahrzeugs 2 miteinander verbunden sind. Dabei ist die Antenne 8 über einen ersten Pfad mit einem ersten Ende der Leitung 18 und das Gerät 12 über einem zweiten Pfad mit einem zweiten Ende der Leitung 18 verbunden. Entlang jeweils eines Pfads ist jeweils ein Frequenzwandlungsmodul, d. h. das Frequenzreduktionsmodul 10 entlang des ersten Pfads und das Frequenzerhöhungsmodul 14 entlang des zweiten Pfads angeordnet. Hierbei ist vorgesehen, dass zumindest die Komponenten der

Kommunikationseinheit 6 und die Leitung 18 auch als Komponenten des ersten Beispiels des Systems 4 ausgebildet sind. Ferner zeigt Figur 1 auch eine externe Vorrichtung 20 außerhalb des Fahrzeugs 2.

Bei dem ersten Beispiel des Verfahrens tauschen die Antenne 8 und die externe Vorrichtung 20 hochfrequente Signale über elektromagnetische Wellen aus. Dabei ist hier vorgesehen, dass die hochfrequenten Signale eine analoge Struktur aufweisen, d. h. analog sind, und dass eine Frequenz, mit der die hochfrequenten Signale ausgetauscht werden, einen ersten hohen Wert aufweist, der hier bspw. mindestens 5,9 GHz entspricht. Wenn von der Antenne 8 Signale mit dem ersten hohen Wert für die Frequenz empfangen werden, wird deren Frequenz von dem ersten Frequenzreduktionsmodul 10, hier von einem Mischer 22 sowie einem variablen Frequenzoszillator 24 des Frequenzreduktionsmoduls 10, unter Bereitstellung einer Zwischenfrequenz auf einen zweiten niedrigen Wert gewandelt und somit verringert, wobei eine sogenannte down-conversion durchgeführt wird. Diese dabei erzeugten niederfrequenten Signale mit dem zweiten niedrigen Wert für die Frequenz von hier bspw. maximal 2 GHz werden weiterhin über die Leitung 18 an das Gerät 12 übertragen und weiterhin von dem Frequenzerhöhungsmodul 14 in dem Gerät 12, das ebenfalls einen Mischer 26 und einen Frequenzoszillator 28 aufweist, auf einen höheren Wert, bspw. den ursprünglichen ersten hohen Wert im Rahmen einer sog. up-conversion gewandelt und somit erhöht, wobei diese hochfrequenten Signale hier weiterhin an den Transceiver 16 des Geräts 12 geleitet und weiter verarbeitet werden.

Falls umgekehrt im Rahmen des Austausches von Signalen ursprünglich hochfrequente Signale ausgehend von dem Gerät 12 über die Leitung 18 und die Antenne 8 zu der externen Vorrichtung 20 zu übertragen sind, wird für diese Signale von einem weiteren, hier nicht dargestellten Frequenzreduktionsmodul entlang des zweiten Pfads die Frequenz auf den zweiten niedrigen Wert eingestellt. Diese niederfrequenten Signale werden weiterhin über die Leitung 18 zu der Kommunikationseinheit 6 übermittelt. Weiterhin wird von einem weiteren, hier nicht dargestellten Frequenzerhöhungsmodul entlang des ersten Pfads die Frequenz der niederfrequenten Signale auf den ersten hohen Wert erhöht. Weiterhin werden die hochfrequenten Signale von der Antenne 8 zu der externen Vorrichtung 20 gesendet.

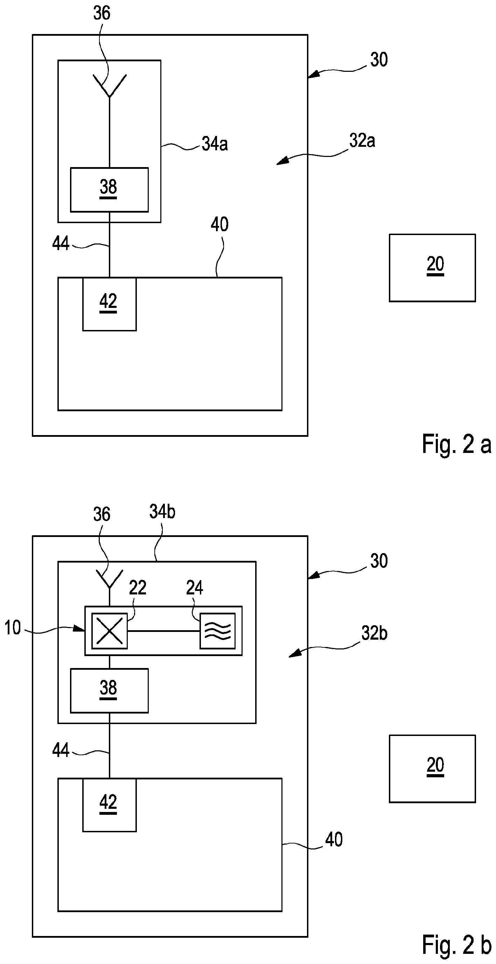

Die Figuren 2a und 2b zeigen jeweils in schematischer Darstellung ein als Kraftfahrzeug 30 ausgebildetes Fahrzeug, das in Figur 2a eine erste Variante eines Systems 32a und in Figur 2b eine zweite Variante als Ausführungsform des erfindungsgemäßen Systems 32b aufweist. Dabei umfasst das Fahrzeug 30 bei beiden Varianten eine Kommunikationseinheit 34a bzw. 34b mit einer Antenne 36 und mindestens einem Signalwandlungsmodul 38, das hier als Strukturwandlungsmodul ausgebildet und/oder zu bezeichnen ist. Dabei sind die Antenne 36 und der Analog-Digital-Wandler 38 in einen Chip integriert. Außerdem weist das Fahrzeug 30 in beiden Varianten ein hier als Steuergerät ausgebildetes Gerät 40 auf, an dessen Eingang ein weiteres Signalwandlungsmodul, insbesondere Strukturwandlungsmodul, angeordnet ist, das hier als Digital-Analog-Wandler 42 ausgebildet ist. Weiterhin sind die Kommunikationseinheit 34a bzw. 34b und das Gerät 40 hier über eine physische Leitung 44 des Fahrzeugs 30 miteinander verbunden. Dabei ist die Antenne 36 über einen ersten Pfad mit einem ersten Ende der Leitung 44 und das Gerät 40 über einem zweiten Pfad mit einem zweiten Ende der Leitung 44 verbunden. Entlang jeweils eines Pfads ist jeweils ein Strukturwandlungsmodul, d. h. der Analog-Digital-Wandler 38 entlang des ersten Pfads und der Digital-Analog-Wandler 40 entlang des zweiten Pfads angeordnet.

Außerdem zeigen beide Figuren 2a, 2b eine externe Vorrichtung 20 außerhalb des Fahrzeugs 30. Bei beiden Varianten des Verfahrens ist vorgesehen, dass zwischen dem Gerät 40 des Fahrzeugs 30 und der externen Vorrichtung 20 Signale ausgetauscht werden. Dabei werden zwischen der Antenne 36 und der externen Vorrichtung 20 jeweils über elektromagnetische Wellen analoge hochfrequente Signale ausgetauscht, die eine Frequenz mit einem ersten hohen Wert aufweisen.

Bei der ersten Variante des Verfahrens werden zumindest die Antenne 36 und die beiden Strukturwandlungsmodule als Komponenten der ersten Variante der Ausführungsform des Systems 32a verwendet. Sobald die Antenne 36 ein analoges hochfrequentes Signal mit der Frequenz mit dem ersten hohen Wert empfängt, wird dieses von dem ersten Strukturwandlungsmodul, das hier als Analog-Digital-Wandler 38 ausgebildet ist, ausgehend von seiner analogen Struktur digitalisiert. Das nunmehr digitalisierte Signal wird weiterhin über die hier aus Kupfer oder einem anderen elektrisch leitfähigen Material gefertigte Leitung 44 zu dem zweiten Strukturwandlungsmodul, das hier als Digital-Analog-Wandler 42 ausgebildet ist, übermittelt, von diesem analogisiert und somit in eine analoge Struktur gewandelt sowie dem Gerät 40 für eine weitere Bearbeitung bereitgestellt.

Falls umgekehrt ein Signal von dem Gerät 40 zu der externen Vorrichtung 20 gesendet werden soll, wird das hier ursprünglich analoge Signal von einem nicht dargestellten Analog-Digital-Wandler als Strukturwandlungsmodul entlang des zweiten Pfads in ein digitales Signal umgewandelt und über die Leitung 44 zu einem nicht dargestellten Digital-Analog-Wandler als Strukturwandlungsmodul entlang des ersten Pfads übermittelt. Dieses übermittelte digitale Signal wird weiterhin von dem Digital-Analog-Wandler wieder in ein analoges Signal umgewandelt, das weiterhin von der Antenne 36 an die Vorrichtung 20 gesendet und somit übermittelt wird.

Bei der zweiten Variante der Ausführungsform des erfindungsgemäßen Systems 32b ist vorgesehen, dass die zweite Variante der Kommunikationseinheit 34b zusätzlich ein Signalwandlungsmodul aufweist, das hier als Frequenzreduktionsmodul 10 ausgebildet ist und einen Mischer 22 sowie einen variablen Frequenzoszillator 24 aufweist sowie ebenfalls wie die Antenne 36 und der Analog-Digital-Wandler 38 in einem Chip integriert ist. Bei der zweiten Variante der zweiten Ausführungsform des Verfahrens wird das analoge hochfrequente Signal, das hier die Frequenz mit dem ersten hohen Wert aufweist, ausgehend von der externen Vorrichtung 20 versendet und somit an die Antenne 36 übermittelt.

Nun ist zusätzlich zu der ersten Variante des Verfahrens vorgesehen, dass die Frequenz des von der Antenne 36 empfangenen analogen Signals von dem Frequenzreduktionsmodul 10 im Rahmen einer down-conversion auf einen zweiten niedrigen Wert reduziert und nachfolgend durch den Analog-Digital-Wandler 38 digitalisiert wird. Dieses digitalisierte niederfrequente Signal mit dem zweiten niedrigen Wert für die Frequenz wird weiterhin über die Leitung 44 zu dem Digital-Analog-Wandler 42 am Eingang bzw. Ausgang des Geräts 40 übermittelt. Umgekehrt ist hier vorgesehen, dass ein digitales Signal mit dem zweiten niedrigen Wert für die Frequenz ausgehend von dem Gerät 40 über die Leitung 44 zunächst an den Digital-Analog-Wandler in der Kommunikationseinheit 34b übermittelt und von diesem analogisiert wird. Weiterhin wird die Frequenz des nunmehr analogisierten Signals von einem nicht dargestellten Frequenzerhöhungsmodul entlang des ersten Pfads auf den ersten hohen Wert erhöht und das dabei erzeugte hochfrequente Signal von der Antenne 36 an die externe Vorrichtung 20 übermittelt.

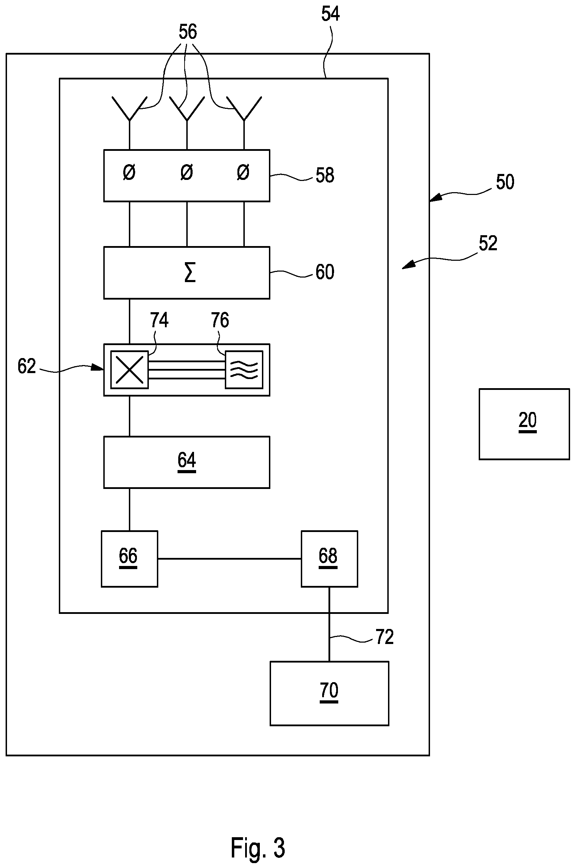

Figur 3 zeigt in schematischer Darstellung ein weiteres hier als Kraftfahrzeug ausgebildetes Fahrzeug 50, das ein weiteres Beispiel eines Systems 52 aufweist. Dabei weist das Fahrzeug 50 eine Kommunikationseinheit 54 auf, die hier drei Antennen 56, die ein Antennenarray bilden, einen den Antennen 56 nachgeschalteten Phasenschieber 58, einen Kombinierer 60, der dem Phasenschieber 58 nachgeschaltet ist, und ein dem Kombinierer 60 sowie auch den Antennen 56 nachgeschaltetes Frequenzreduktionsmodul 62 als Signalwandlungsmodul auf. Weiterhin weist die Kommunikationseinheit 54 ein dem Frequenzreduktionsmodul 62 nachgeschaltetes Filterfrontend 64 bzw. einen Filtervorbau, einen diesem nachgeschalteten Transceiver 66 sowie eine nachgeschaltete Schnittstelle 68, hier eine digitale Schnittstelle für ein Ethernet, auf. Dabei sind hier sämtliche Komponenten der Kommunikationseinheit 54 in einem und/oder auf einem Chip integriert.

Außerdem umfasst das Fahrzeug 50 ein hier als Steuergerät ausgebildetes Gerät 70. Dabei sind die Kommunikationseinheit 54 und das Gerät 70 über eine physische elektrisch leitende, aus Metall gebildete Leitung 72 des Fahrzeugs 50 miteinander verbunden. Hierbei ist vorgesehen, dass zumindest die Komponenten der Kommunikationseinheit 54 und die Leitung 72 auch als Komponenten der dritten Ausführungsform des Systems 52 ausgebildet sind. Ferner zeigt Figur 3 auch eine externe Vorrichtung 20 außerhalb des Fahrzeugs 50. Dabei sind die Antennen 56 über einen ersten Pfad mit einem ersten Ende der Leitung 72 und das Gerät 70 über einem zweiten Pfad mit einem zweiten Ende der Leitung 72 verbunden. Entlang des ersten Pfads ist das Frequenzreduktionsmodul 62 angeordnet.

Bei dem weiteren Verfahren tauschen die Antennen 56 und die externe Vorrichtung 20 über elektromagnetische Wellen hochfrequente Signale aus. Dabei ist hier vorgesehen, dass die Signale eine analoge Struktur bzw. Form aufweisen und demnach analog sind, und dass eine Frequenz, mit der die hochfrequenten Signale ausgetauscht werden, einen ersten hohen Wert aufweist, der hier bspw. mindestens 5,9 GHz entspricht. Wenn von den Antennen hochfrequente Signale mit dem ersten hohen Wert für die Frequenz empfangen werden, werden diese zunächst von dem Phasenschieber 58 gebündelt und von dem Kombinierer 60 kombiniert, wobei die Signale nach derartigen Verarbeitungen immer noch die Frequenz mit dem ersten hohen Wert aufweisen. Danach wird die Frequenz der Signale von dem Frequenzreduktionsmodul 62, hier von einem Mischer 74 sowie einem variablen Frequenzoszillator 76 des Frequenzreduktionsmoduls 62, auf einen zweiten niedrigen Wert für die Frequenz bzw. eine Zwischenfrequenz gewandelt und somit verringert, wobei eine sogenannte down-conversion durchgeführt wird. Diese dabei erzeugten niederfrequenten Signale mit dem zweiten niedrigen Wert für die Frequenz von hier bspw. maximal 2 GHz durchlaufen nachfolgend das Filterfrontend 64 und den Transceiver 66 und erreichen dann die Schnittstelle 68. Ausgehend von dieser werden die Signale mit dem zweiten niedrigen Wert für die Frequenz über die Leitung 72 zu dem Gerät 70 übertragen und von diesem bearbeitet und/oder ausgewertet.

Alle vorgestellten Systeme 4, 32a, 32b, 52 haben gemeinsam, dass zwischen mindestens einer Antenne 8, 36, 56 eines Fahrzeugs 2, 30, 50 und der externen Vorrichtung 20, in der Regel mit mindestens einer Antenne dieser Vorrichtung 20, die ebenfalls als Fahrzeug ausgebildet sein kann, bei einer relativen Bewegung des Fahrzeugs 2, 30, 50 zu der Vorrichtung 20 die hochfrequenten Signale ausgetauscht werden, die hier bspw. gemäß einem Standard 5G für eine fünfte Generation für mobile Netzwerke ausgebildet sind. Falls diese hochfrequenten Signale ausgehend von der mindestens einen Antenne 8, 36, 56 über die Leitung 18, 44, 72 direkt an das Gerät 12, 40, 70 des Fahrzeugs 2, 30, 50 übertragen werden sollen, besteht die Gefahr, dass während eines Transports dieser Signale aufgrund ihres hohen Werts für die Frequenz von mehreren Gigahertz entlang der Leitung 18, 44, 72 erhebliche Leitungsverluste, bspw. eine Leitungsdämpfung, entstehen kann.

Durch Vorsehen eines Systems 4, 32a, 32b, 52 für ein derartiges Fahrzeug 2, 30, 50 mit mindestens einem Signalwandlungsmodul, d. h. mindestens einem Frequenzreduktionsmodul 10, 62 und/oder Analog-Digital-Wandler 38, werden bei einem Verfahren die ursprünglich hochfrequenten Signale in niederfrequente Signale umgewandelt und/oder digitalisiert. Bei einem Transport derartiger niederfrequenter und/oder digitaler Signale entlang der Leitung 18, 44, 72 zu dem Gerät 12, 40, 70 werden die ansonsten auftretenden Leitungsverluste reduziert.

### Bezugsziffern

Fahrzeug 2
System 4
Kommunikationseinheit 6
Antenne 8
Frequenzreduktionsmodul 10
Gerät 12
Frequenzerhöhungsmodul 14
Transceiver 16
Leitung 18
Vorrichtung 20
Mischer 22
Frequenzoszillator 24
Mischer 26
Frequenzoszillator 28
Fahrzeug 30
System 32a
System 32b
Kommunikationseinheit 34a
Kommunikationseinheit 34b
Antenne 36
Analog-Digital-Wandler 38
Gerät 40
Digital-Analog-Wandler 42
Leitung 44
Fahrzeug 50
System 52
Kommunikationseinheit 54
Antenne 56
Phasenschieber 58
Kombinierer 60
Frequenzreduktionsmodul 62
Filterfrontend 64
Transceiver 66
Schnittstelle 68
Gerät 70
Leitung 72
Mischer 74
Frequenzoszillator 76

## Patentansprüche

1. System zum Austauschen von Signalen zwischen einem Gerät (12, 40, 70) eines Fahrzeugs (2, 30, 50) und einer externen Vorrichtung (20) außerhalb des Fahrzeugs (2, 30, 50) über mindestens eine Antenne (8, 36, 56) des Fahrzeugs (2, 30, 50), wobei hochfrequente Signale mit einem hohen Wert einer Frequenz zwischen der mindestens einen externen Vorrichtung (20) und der mindestens einen Antenne (8, 36, 56) des Fahrzeugs (2, 30, 50) über elektromagnetische Wellen ausgetauscht werden, wobei die mindestens eine Antenne (8, 36, 56) über mindestens einen ersten Pfad mit einem ersten Ende einer Leitung (18, 44, 72) des Fahrzeugs (2, 30, 50) und das Gerät (12, 40, 70) über mindestens einen zweiten Pfad mit einem zweiten Ende der Leitung (18, 44, 72) des Fahrzeugs (2, 30, 50) verbunden ist, wobei das System (4, 32a, 32b, 52) mindestens einen Analog-Digital-Wandler (38) aufweist, der entlang mindestens eines der beiden Pfade angeordnet ist, wobei der mindestens eine Analog-Digital-Wandler (38) dazu ausgebildet ist, die Signale vor einem Transport entlang der Leitung (44) zu digitalisieren, und wobei das System (4, 32a, 32b, 52) mindestens einen Digital-Analog-Wandler (42) aufweist, der entlang mindestens eines der Pfade angeordnet ist, wobei der mindestens eine Digital-Analog-Wandler dazu ausgebildet ist, die Signale nach dem Transport entlang der Leitung (18, 44, 72) zu analogisieren, **dadurch gekennzeichnet, dass** das System (4, 32a, 32b, 52) mindestens ein Frequenzreduktionsmodul (10, 62) aufweist, das entlang mindestens eines der Pfade angeordnet ist, wobei das mindestens eine Frequenzreduktionsmodul (10, 62) dazu ausgebildet ist, den Wert der Frequenz der hochfrequenten Signale vor einem Transport entlang der Leitung (18, 44, 72) auf einen niedrigen Wert einzustellen, wobei das System (4, 32a, 32b, 52) mindestens ein Frequenzerhöhungsmodul (14) aufweist, das entlang mindestens eines der Pfade angeordnet ist, wobei das mindestens eine Frequenzerhöhungsmodul (14) dazu ausgebildet ist, niederfrequente Signale nach dem Transport entlang der Leitung (18, 44, 72) wieder auf den ursprünglichen hohen Wert der Frequenz einzustellen, wobei die mindestens eine Antenne (8, 36, 56), das mindestens eine Frequenzreduktionsmodul (10, 62) und der mindestens eine Analog-Digital-Wandler (38) entlang dem mindestens einen ersten Pfad auf einem Baustein angeordnet sind.

2. Verfahren zum Austauschen von Signalen zwischen mindestens einem Gerät (12, 40, 70) eines Fahrzeugs (2, 30, 50) und mindestens einer externen Vorrichtung (20) mit einem System (4, 32a, 32b, 52) nach Anspruch 1.

3. Verfahren nach Anspruch 2, bei dem der hohe Wert der Frequenz der hochfrequenten Signale mindestens so groß wie 5 GHz ist.

## Claims

1. A system for exchanging signals between a device (12, 40, 70) of a vehicle (2, 30, 50) and an external apparatus (20) outside of the vehicle (2, 30, 50) via at least one antenna (8, 36, 56) of the vehicle (2, 30, 50), wherein high-frequency signals with a high value of a frequency are exchanged between the at least one external apparatus (20) and the at least one antenna (8, 36, 56) of the vehicle (2, 30, 50) via electromagnetic waves, wherein the at least one antenna (8, 36, 56) is connected to a first end of a line (18, 44, 72) of the vehicle (2, 30, 50) via at least one first path, and the device (12, 40, 70) is connected to a second end of the line (18, 44, 72) of the vehicle (2, 30, 50) via at least one second path, wherein the system (4, 32a, 32b, 52) has at least one analog-to-digital converter (38) that is disposed along at least one of the two paths, wherein the at least one analog-to-digital converter (38) is designed to digitize the signals before a transport along the line (44), and wherein the system (4, 32a, 32b, 52) has at least one digital-to-analog converter (42) that is disposed along at least one of the paths, wherein the at least one digital-to-analog converter is designed to analogize the signals after the transport along the line (18, 44, 72), **characterized in that** the system (4, 32a, 32b, 52) has at least one frequency reduction module (10, 62) that is disposed along at least one of the paths, wherein the at least one frequency reduction module (10, 62) is designed to set the value of the frequency of the high-frequency signals to a low value before a transport along the line (18, 44, 72), wherein the system (4, 32a, 32b, 52) has at least one frequency increase module (14) that is disposed along at least one of the paths, wherein the at least one frequency increase module (14) is designed to set lowfrequency signals back to the original high value of the frequency after the transport along the line (18, 44, 72), wherein the at least one antenna (8, 36, 56), the at least one frequency reduction module (10, 62), and the at least one analog-to-digital converter (38) are disposed along the at least one first path on a chip.

2. A method for exchanging signals between at least one device (12, 40, 70) of a vehicle (2, 30, 50) and at least one external apparatus (20) using a system (4, 32a, 32b, 52) according to claim 1.

3. The method according to claim 2, wherein the high value of the frequency of the high-frequency signals is at least as high as 5 GHz.

## Revendications

1. Système d'échange de signaux entre un appareil (12, 40, 70) d'un véhicule (2, 30, 50) et un dispositif externe (20) à l'extérieur du véhicule (2, 30, 50) par l'intermédiaire d'au moins une antenne (8, 36, 56) du véhicule (2, 30, 50), dans lequel des signaux à haute fréquence ayant une valeur de fréquence élevée sont échangés entre le au moins un dispositif externe (20) et la au moins une antenne (8, 36, 56) du véhicule (2, 30, 50) par ondes électromagnétiques, la au moins une antenne (8, 36, 56) étant reliée par au moins un premier chemin à une première extrémité d'une ligne (18, 44, 72) du véhicule (2, 30, 50) et le dispositif (12, 40, 70) étant relié par au moins un deuxième chemin à une deuxième extrémité de la ligne (18, 44, 72) du véhicule (2, 30, 50), le système (4, 32a, 32b, 52) présentant au moins un convertisseur analogique/numérique (38) disposé le long d'au moins l'un des deux chemins, ledit au moins un convertisseur analogique/numérique (38) étant conçu pour numériser les signaux avant un transport le long de la ligne (44), et dans lequel le système (4, 32a, 32b, 52) présente au moins un convertisseur numérique/analogique (42) disposé le long d'au moins l'un des chemins, ledit au moins un convertisseur numérique/analogique étant conçu pour rendre analogiques les signaux après transport le long de la ligne (18, 44, 72), **caractérisé en ce que** le système (4, 32a, 32b, 52) présente au moins un module de réduction de fréquence (10, 62) disposé le long d'au moins l'un des chemins, ledit au moins un module de réduction de fréquence (10, 62) étant conçu pour régler la valeur de la fréquence des signaux à haute fréquence à une valeur basse avant un transport le long de la ligne (18, 44, 72), le système (4, 32a, 32b, 52) présentant au moins un module d'augmentation de fréquence (14) disposé le long d'au moins l'un des chemins, ledit au moins un module d'augmentation de fréquence (14) étant conçu pour rétablir les signaux à basse fréquence à la valeur élevée initiale de la fréquence après le transport le long de la ligne (18, 44, 72), ladite au moins une antenne (8, 36, 56), ledit au moins un module de réduction de fréquence (10, 62) et ledit au moins un convertisseur analogique/numérique (38) étant disposés sur un module le long dudit au moins un premier chemin.

2. Procédé d'échange de signaux entre au moins un appareil (12, 40, 70) d'un véhicule (2, 30, 50) et au moins un dispositif externe (20) doté d'un système (4, 32a, 32b, 52) selon la revendication 1.

3. Procédé selon la revendication 2, dans lequel la valeur élevée de la fréquence des signaux à haute fréquence est au moins égale à 5 GHz.
